# EUROPEAN PATENT APPLICATION

(11) **EP 3 176 594 A2**
(43) Date of publication of application: **07.06.2017**
(21) Application number: 16198010.7
(22) Date of filing: 09.11.2016
(51) Int. Cl.: G01R 21/133, G01R 1/20, G01R 35/04, G01R 31/02

(54) **ELECTRICITY METER WITH AN IMPROVED MEASUREMENT CIRCUIT**

(30) Priority: 10.11.2015 EP 15193779
(71) Applicant: KAMSTRUP A/S, 8660 Skanderborg (DK)
(72) Inventor: Hansen, Jan Tejlgaard, 8752 Østbirk (DK); Kirkegaard, Dennis, 8850 Bjerringbro (DK)
(74) Representative: Plougmann Vingtoft a/s

(57) **Abstract**

An electricity meter (10) for measuring electricity consumption supplied to a consumption site, the electricity meter comprising: a shunt-resistor (1a, 1b, 1c, 1d) arranged in line with each of the live and/or neutral conductors connected with the electricity meter; and an energy processing system (20) for simultaneously determining the current passing through each of the live and neutral conductors based on a potential difference measured across the respective shunt-resistors (1a, 1b, 1c, 1d), the energy processing system being adapted to detect the presence, magnitude and time of occurrence of a leak current at the consumption site, by summation of the determined currents running simultaneously in the live and/or neutral conductors. The energy processing system comprises a plurality of energy processing units (202a, 202b, 202c, 202d) in electrical communication with a common supplementary energy processing unit (201), wherein the energy processing units initiate sampling of the current running in the respective shunt-resistors based on a clock signal received from the supplementary energy processing unit (201), and wherein the shunt-resistor comprises a resistance element provided with a groove milled in a transversal direction between two opposite contacts points.

## Description

### FIELD OF THE INVENTION

The present invention relates to an electricity meter for measuring electricity consumption supplied to a consumption site, and for detecting earth fault conditions. The invention further relates to a shunt-resistor for such an electricity meter and to a method for the manufacture of such a shunt-resistor.

### BACKGROUND OF THE INVENTION

Electricity meters are widely used for measuring electricity consumption for invoicing purposes also referred to as metering. In addition to invoicing purposes, measurements may also be used for other purposes related to system monitoring, demand monitoring and failure mode detection.

Ground faults or earth faults are one type of faults that may cause potentially life threatening situations wherein currents of significant magnitude leak from an electrical circuit and run into the ground. Earth current or residual current running through the ground may be dangerous to both humans and animals and are caused by system failures, such as a defective electrical devices.

For both metering and fault detection purposes, the accuracy of the electricity meter is of significant importance. Meters must be able to measure power consumption precisely over extended periods of time without the need for calibration. In relation to failure detection meters should simultaneously be able to accurately measure both large and very small currents in the range from milliampere [mA] to ampere [A].

These demands require electrical meters with robust and precise measurements circuits.

### OBJECT OF THE INVENTION

An object of the present invention is to provide an electricity meter that provides an alternative to the prior art and an electricity meter with an improved measurement circuit.

### SUMMARY OF THE INVENTION

Thus, the above described object and several other objects are intended to be obtained in a first aspect of the invention by providing an electricity meter for measuring electricity consumption supplied to a consumption site, the electricity meter having a measuring circuit for measuring the electricity consumption supplied via one or more live and/or neutral conductors and for detecting earth fault conditions, comprising: a shunt-resistor arranged in line with each of the live and/or neutral conductors connected with the electricity meter; an energy processing system for simultaneously determining the current passing through each of the live and neutral conductors based on a potential difference measured across the respective shunt-resistors, the energy processing system being adapted to detect the presence, magnitude and time of occurrence of a leak current at the consumption site, by summation of the determined currents running simultaneously in the live and/or neutral conductors; a memory module adapted to receive and store data indicative of earth fault from the energy processing system; and a communication module adapted to provide communication between the electricity meter and a utility server, the communication module being adapted to receive data indicative of earth fault from the energy processing system and to transmit said data to the utility server; wherein the energy processing system comprises a plurality of energy processing units each in electrical communication with a respective shunt-resistor and communicating with a common supplementary energy processing unit, wherein each of the energy processing units are configured to initiate sampling of the current running in the respective shunt-resistors based on a dedicated clock signal received from the supplementary energy processing unit, and wherein the supplementary energy processing unit is adapted to synchronize sampling performed by each of the energy processing units by controlling a clock rate frequency of the dedicated clock signal transmitted to each of the energy processing units.

The invention further relates to a shunt-resistor for a measuring circuit of an electricity meter adapted to detect earth fault conditions, comprising: two contact elements providing an input terminal and an output terminal, respectively; and a resistance element extending in a longitudinal direction between the two contact elements, the resistance element having a contact surface and being provided with at least two measuring terminals; wherein the contact elements are secured to the contact surface of the resistance element at opposite contact points and that a groove is milled in the contact surface of the resistance element in a transversal direction between the contacts points.

Furthermore, the groove of the above-mentioned shunt-resistor may at least partially overlap the measuring terminals. Additionally, the measuring terminals may be formed as an integral part of the resistance element extending in the transversal direction. Further, the contact elements may be secured to the contact surface of the resistance element by welding or soldering. Still further, each of the measuring terminals of the, when seen in a direction towards the contact surface of the resistance element, may comprise a straight base section proximal the resistance element and a distal head section being wider than the base section and the groove may extend onto at least the base section of the measuring terminals.

Still further, the invention relates to a method for the manufacture of a shunt-resistor as described above, comprising the steps of: welding or soldering contact elements onto a resistance element to provide a shunt-resistor, fixating the shunt resistor in an fixation device that centers the resistance element, removing material from both the resistance element and the contact elements by milling, along a transversal center line of the resistance element, a groove in the shunt resistor.

The above described electricity meter, shunt-resistor and method for the manufacture of the same is particularly, but not exclusively, advantageous for obtaining an improved measurement circuit for determining residual currents.

By milling a groove in the resistance element of a shunt resistor between the contact elements, the distal end of the contact elements are precisely positioned in relation to the measuring terminals. By accurately controlling the position of the contact element in relation to the resistance element and the mutual distance between the contact elements, a shut resistor with a high relative accuracy is achieved. Further, by arranging the contact elements with the lowest possible mutual distance, and accurately relative to the measuring terminals, a shut-resistor having an improved balance between signal strength measurable at the measuring terminals and effect loss across the shut-resistor, is achieved.

### BRIEF DESCRIPTION OF THE FIGURES

The electricity meter according to the invention will now be described in more detail with regard to the accompanying figures. The figures show one way of implementing the present invention and is not to be construed as being limiting to other possible embodiments falling within the scope of the attached claim set.
Figure 1 shows a block diagram of an electricity meter,
Figure 2 shows the construction of a shunt-resistor according to one embodiment,
Figure 3 shows the shunt-resistor of Fig. 2 seen from above,
Figure 4 shows the shunt-resistor of Fig. 2 seen from the side, and
Figure 5 shows a cross section of the shunt-resistor seen along line GG of Fig. 3

### DETAILED DESCRIPTION OF AN EMBODIMENT

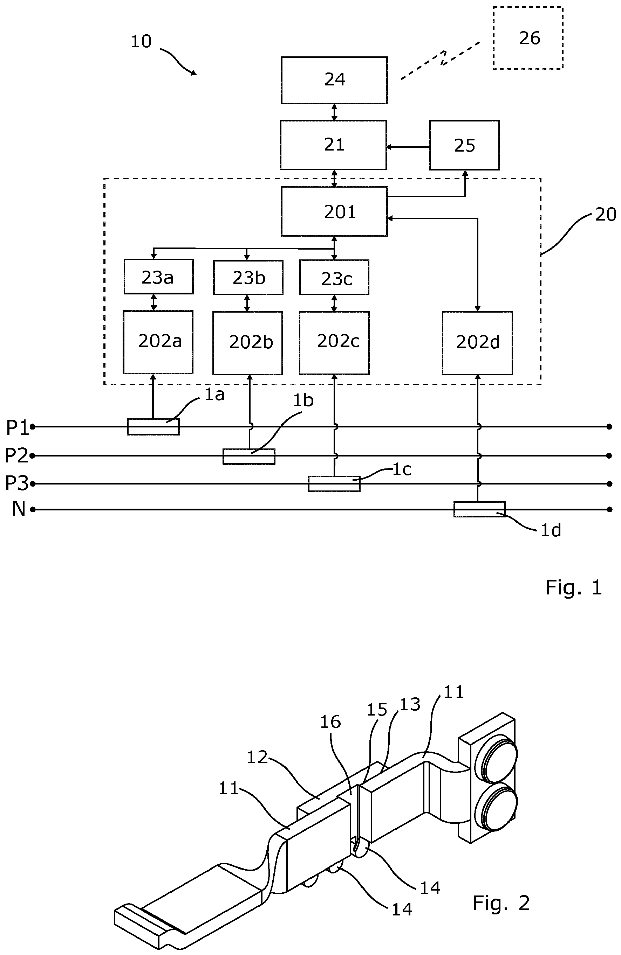

Referring to figure 1, the general construction and functionality of an electricity meter 10 according to an embodiment of the invention will be described. The electricity meter comprises a measuring circuit for measuring the electricity consumption supplied via three live conductors (P1, P2, P3) and a neutral conductor (N). As envisaged by the skilled person the electricity meter may also be adapted to measure electricity consumption supplied via fewer conductors and without a neutral conductor. The electricity meter may for example be connected with only two or three live conductors without the presence of a neutral conductor.

The shown measuring circuit comprises shunt-resistors 1a, 1b, 1c, 1d arranged in series with each of the live conductors and the neutral conductor. The shunt-resistors are connected with energy processing units (EPUs) 202a, 202b, 202c adapted to sample the current running through each of the conductors based on a voltage difference measured across the shunt-resistors. The EPUs are further adapted to measure the voltage in each of the conductors, and based on these current and voltage determinations, determine the energy supplied through each of the conductors.

The EPUs are connected to a supplementary energy processing unit (SEPU) 201 via galvanic isolators 23a, 23b, 23c. Data regarding voltage and current measurements, and calculated energy supply is transferred from the EPUs 202a, 202b, 202c to a supplementary energy processing unit (SEPU) 201 via the galvanic isolators. Similar, electronic signals, such as a clock signal, may be transmitted form the SEPU to the EPUs via the galvanic isolators, as will be further described below.

Voltage- and current measurement data in the neutral conductor is transferred from the energy processing unit 202d to the SEPU 201. In embodiments without a neutral conductor, the shunt 1d and the EPU 202d arranged in connection with the neutral conductor are omitted.

At the SEPU current measurements related to the live and neutral conductors are summarized to determine whether current is leaking from the electrical circuit at the load side of the electricity meter. The SEPU also ensures that sampling performed at the EPUs is synchronized, i.e. that currents determination at the different EPUs based on the shunt-resistor measurements are performed at the same points in time. If the sampling performed at the different EPUs is not sufficiently synchronized, data from each of the EPUs cannot be compared to determine for example current leaks.

Thus, the EPUs 202a, 202b, 202c, 202d and the SEPU 201 together, provide the necessary processing of data to determine amongst others current leaks resulting from system defects at the load side. Consequently, the EPUs and the SEPU thus together constitute an energy processing system 20 of the electricity meter adapted to determining the current passing through each of the live and neutral conductors and to detect the presence, magnitude and time of occurrence of a leak current at the consumption site.

For the purpose of synchronizing sampling at the EPUs, the SEPU 201 is configured to transmit a dedicated clock signal to each of the EPUs. By using clock signals distributed by a common processing unit, i.e. the SEPU, to each of the EPUs, it is possible to synchronize the sample process at each of the EPUs. Hereby, by controlling the clock signal sent to each of the EPUs, the sampling rates of the EPUs 202a, 202b, 202c, 202d are controlled by the SEPU.

In an exemplary embodiment the clock signal from the SEPU has a clock rate frequency of 4,1 MHz. However, it is envisaged by the skilled person that clock signal having clock rates of both higher and lower frequencies may be applied. Each EPU initiates sampling based on the received clock signal and returns sample data to the SEPU. Based on the time of reception of the sample data from each of the EPUs, the SEPU determines whether sampling performed by each EPU is sufficiently synchronized with the sampling of the other EPUs. In an alternative embodiment, each EPU may transmit a separate synchronization signal to the SEPU and based on the synchronization signal the SEPU then determines whether sampling performed by each EPU is sufficiently synchronized.

If the sampling performed at one or more of the EPUs is not sufficiently synchronized, for example if the samplings are received by the SEPU either too early or too late, the clock signal sent to that particular EPU is modified to change the sampling time. The clock signal is modified by reducing the frequency of the clock signal to about half the original frequency for a predetermined period of time. In one embodiment, the original frequency of 4,1 MHz is reduced to 2,05 MHz for 400-500 nanoseconds (ns). It is envisaged by the skilled person that other frequencies and time intervals may be applied to achieve a similar purpose.

Hereby, the sampling time at the respective EPU is delayed until it is sufficiently synchronized with the sampling time of the other EPUs. Synchronization of the sampling time may be achieved through several iterations of modification of the sampling signal. Following one period of modification of the clock signal the SEPU may determine whether the respective EPU is still not sufficiently synchronized. If this is the case the clock signal may be modified again to further synchronize the sampling time of the EPU .

This synchronization of the EPU sampling process may take place both during start-up of the electricity meter and continuously during operation of the electricity meter.

The electricity meter further comprises a control unit 21 controlling the overall operation of the electricity meter, a memory module 25 for storing measurements and calculated values, and a communication module 24 for g communicating via a communication network.

When a current leak is determined, data regarding the presence, magnitude and time of occurrence of the current leak is stored in the memory module 25 and transmitted to the communication module for further distribution. If the electricity meter is part of an automate meter infrastructure (AMI), the current leakage information may be transmitted by the communication module 24 via a wireless- or wired connection to a central utility server 26 arranged at a remote location, e.g. at the premises of a utility company. The current leakage information may be transmitted as an alarm that is picked up at the utility company by a surveillance system, and based on the characteristics of the alarm, different action may be initiated. For example, further system diagnostics may be performed to determine the extent and severity of the detected earth fault. The current leak information may also be used as a basis for disconnecting the power supply to the consumption site, for example as input to a Residual-current device (RCD).

In one embodiment, the communication module 24 is a 2-way communication module adapted to transmit and receive data packets via a communication network. Herby the electricity meter may receive data packets, such as commands to be executed, from the utility server. Such commands may instruct the electricity meter to interrupt the supply of power to the consumption site.

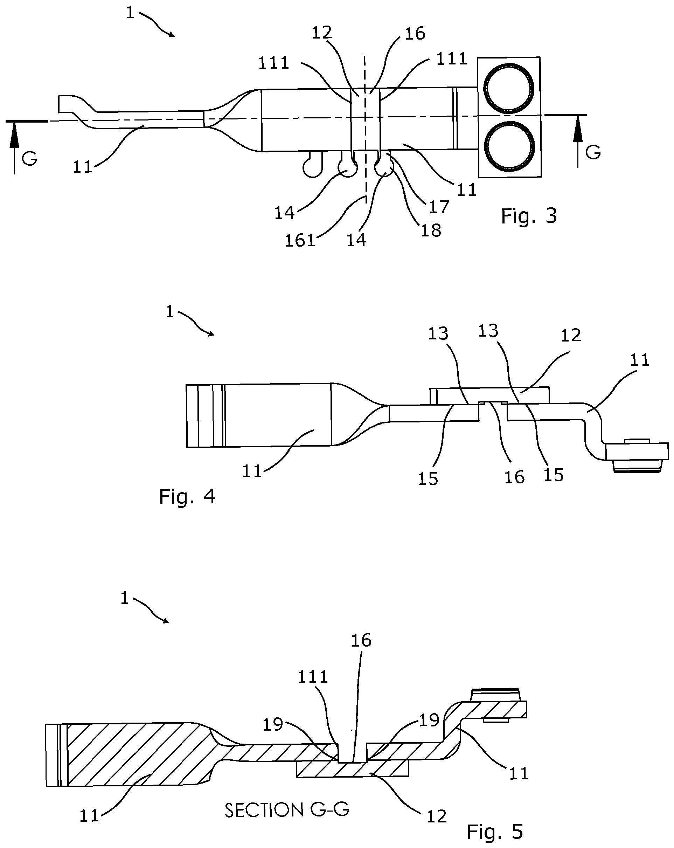

Figures 2 to 5 show a shunt-resistor 1 comprising two contact elements 11 extending from a resistance element 12 in a longitudinal direction. In one embodiment, the contact elements are of a cobber material having a low resistance and excellent current conducting characteristics. The contact elements are adapted for being connected to the supply side and load side of the conductors connected to the electricity meter 1. As seen from the figure, the contact elements are secured to opposite ends of a resistance element 12 extending in the longitudinal direction. In one embodiment, the contact elements are secured to a contact surface 13 of the resistance element 12 by welding using a filler material. The contact elements may also be secured to the resistance element by welding without using a filler material or by soldering.

The resistance element 12 is provided with two measuring terminals 14 extending in a transversal direction from one side of the resistance element itself. The measurement terminals are adapted to be connected to the measurement wires of a measurement circuit. In the above described electricity meter, the measuring terminals are in electrical communication with the EPUs 202a, 202b, 202c, 202d, and the current in the shunt-resistors is thus sampled, i.e. measured, across these terminals.

In the shown embodiment, the measuring terminals are made as an integrated part of the resistance element and the resistance element and measuring terminals may thus be of a monolithic construction. Each of the measuring terminals comprises a straight base section 17 proximal the resistance element and a distal head section 18. The distal head section is wider than the base section and provides a connection surface for the mounting of measurement wires (not shown) to the measuring terminals. In one embodiment, the resistance element and the measuring terminals are of a managing material having a known resistance and a temperature coefficient.

As is seen from the figures, a milled groove 16 is provided in the contact surface of the resistance element in a transversal direction between the contacts points of the contact elements. The groove is centered about a transversal center line 161 of the resistance element and thus removes resistance element material between the contact elements. It is also seen that the milled groove extends onto the base sections of the measuring terminals. Hereby any material of the contact elements, such as cobber, or any material resulting from the joining of the resistance element and contact elements, such as weld pool are removed from identical parts of each of the base sections of the measuring terminals. In the shown embodiment, a groove of a certain dept is provided in the surface of the resistor element. The depth of the groove in the shown embodiment corresponds to approximately 15 percent (15%) of the maximum thickness of the resistance element. However, other embodiments using alternative depths, both smaller and greater, may be envisaged without departing from the underlying invention. In fact, the groove may be of zero depth in relation to the original surface of the resistance element so that only contact element material and/or material resulting from the joining of the contact elements and resistance element are removed when the groove is milled.

The milled groove thus accurately controls the position of the contact elements in relation to the measurement terminals. The precise positioning of the contact elements is essential to the accuracy of the shunt-resistor as variations in the position of the contact elements in relation to the resistance element influence the accuracy of the current measurements across the resistance element.

As the contact elements have a lower resistance that the resistance element, electrodes tend to run through the contact elements as far as possible. At the transition point 19 between each of the contact elements and the resistance element, i.e. the point of contact between the resistance element and the distal end 111 of each of the contact elements, the electrons thus tend to leave the contact elements and run through the resistance element. The electron concentration thus becomes higher at the transition points 19 and the position of the transition points becomes a determining factor for the accuracy of the shunt-resistor.

Further, the above described shunt-resistor renders possible a less demanding manufacturing process. The shunt-resistor may be manufactured by a method wherein the resistor element and the contact elements are assembled by welding or soldering, fixating the contact elements onto the resistance element. Subsequently, the resulting shunt-resistor assembly is fixated in a fixation device that centers the resistance element. Hereby a groove may be milled along a transversal center line 161 of the resistance element. By milling the groove material may be removed from both the resistance element and/or the contact elements. A described previously, the milling of the groove ensures a proper alignment and positioning of the contact element in relation to the measuring terminals of the resistor elements.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. An electricity meter (10) for measuring electricity consumption supplied to a consumption site, the electricity meter having a measuring circuit for measuring the electricity consumption supplied via one or more live and/or neutral conductors and for detecting earth fault conditions, comprising:
- a shunt-resistor (1a, 1b, 1c, 1d) arranged in line with each of the live and/or neutral conductors connected with the electricity meter;
- an energy processing system (20) for simultaneously determining the current passing through each of the live and neutral conductors based on a potential difference measured across the respective shunt-resistors, the energy processing system being adapted to detect the presence, magnitude and time of occurrence of a leak current at the consumption site, by summation of the determined currents running simultaneously in the live and/or neutral conductors;
- a memory module adapted to receive and store data indicative of earth fault from the energy processing system; and
- a communication module adapted to provide communication between the electricity meter and a utility server (26), the communication module being adapted to receive data indicative of earth fault from the energy processing system and to transmit said data to the utility server;
**characterized in that** the energy processing system comprises a plurality of energy processing units (202a, 202b, 202c, 202d) each in electrical communication with a respective shunt-resistor and communicating with a common supplementary energy processing unit (201), wherein each of the energy processing units are configured to initiate sampling of the current running in the respective shunt-resistors based on a dedicated clock signal received from the supplementary energy processing unit, and wherein the supplementary energy processing unit is adapted to synchronize sampling performed by each of the energy processing units by controlling a clock rate frequency of the dedicated clock signal transmitted to each of the energy processing units.

2. An electricity meter (10) according to claim 1, wherein synchronization is achieved by reducing the clock rate frequency to half the original clock rate frequency for a predetermined period of time.

3. An electricity meter (10) according to claim 2, wherein the clock rate frequency is reduced from 4,1 MHz to 2,05 MHz for 400-500 nanoseconds.

4. An electricity meter (10) according to any of the preceding claims, wherein each of the plurality of energy processing units (202a, 202b, 202c) in electrical communication with a shunt-resistor associated with a live conductor (P1, P2, P3), is galvanic isolated from the supplementary energy processing unit by a galvanic isolator (23a, 23b, 23c).

5. An electricity meter (10) according to any of the preceding claims, wherein the shunt-resistor (1) comprises:
- two contact elements (11) providing an input terminal and an output terminal, respectively; and
- a resistance element (12) extending in a longitudinal direction between the two contact elements, the resistance element having a contact surface (13) and being provided with at least two measuring terminals (14); and
wherein the contact elements are secured to the contact surface of the resistance element at opposite contact points (15) and a groove (16) is milled in the contact surface of the resistance element in a transversal direction between the contacts points.

6. An electricity meter (10) according to claim 5, wherein the groove milled in the contact surface of the resistance element at least partially overlaps the measuring terminals.

7. An electricity meter (10) according to claims 5 or 6, wherein the measuring terminals of the resistance element are formed as an integral parts of the resistance element extending in the transversal direction.

8. An electricity meter (10) according to any of the preceding claims 5-7, wherein the contact elements are secured to the contact surface of the resistance element by welding or soldering.

9. An electricity meter (10) according to any of the preceding claims 5-8, wherein each of the measuring terminals, when seen in a direction towards the contact surface of the resistance element, comprises a straight base section (17) proximal the resistance element and a distal head section (18) being wider than the base section and wherein the groove extends onto at least the base section of the measuring terminals.
